# EUROPÄISCHE PATENTANMELDUNG

(11) **EP 4 510 789 A1**
(43) Veröffentlichungstag der Anmeldung: **19.02.2025**
(21) Anmeldenummer: 23191948.1
(22) Anmeldetag: 17.08.2023
(51) Int. Cl.: H05K 7/20

(54) **AUTOMATISIERUNGSGERÄT MIT KÜHLKÖRPER**

(71) Anmelder: Siemens Aktiengesellschaft, 80333 München (DE)
(72) Erfinder: Bergmann, Martin, 92253 Schnaittenbach (DE); Stein, Ulf, 92421 Schwandorf (DE)
(74) Vertreter: Siemens Patent Attorneys

(57) **Zusammenfassung**

Die Erfindung betrifft ein Automatisierungsgerät (1) ausgestaltet für den Einsatz in
einem Automatisierungsumfeld zur Automatisierung eines industriellen Prozesses, aufweisend
ein Grundgehäuse (2) umfassend eine Rückseite (RS) eine Oberseite (OS), eine Unterseite (US), ein erstes Seitenteil (S1) und ein zweites Seitenteil (S2), wodurch eine Kastenform gegeben ist, die Rückseite (RS) ist zur Montage an einem Montagemittel ausgestaltet, eine Leiterplatte (L) ist parallel zu dem ersten Seitenteil (S1) und dem zweiten Seitenteil (S2) rechtwinklig zu der Oberseite (OS) bzw. der Unterseite (US) angeordnet, die Leiterplatte (L) trägt einen Mikroprozessor (3), welcher wiederum mit einem Kühlkörper (4) in thermischer Verbindung steht, der Kühlkörper (4) weist Kühlbleche auf, wobei der Kühlkörper (4) eine Mehrzahl an Kühlblechen (K1,...,K9) aufweist, welche parallel zur Leiterplatte (L) mit jeweils einem Zwischenraum zueinander angeordnet sind und somit für eine erste Einbaulage (E1), in welcher die Unterseite (US) waagerecht ausgerichtet ist, es einem Kühlmedium (KM) möglich ist von der Unterseite (US) durch die Zwischenräume zu strömen, wobei die Kühlbleche (K1,...,K9) einen erste Fläche (F1), eine zweite Fläche (F2) und eine dritte Fläche (F3) aufweisen, dabei ist die zweite Fläche (F2) zwischen der ersten und der dritten Fläche (F3) derart angeordnet, das die zweite Fläche (F2) eine schiefe Ebene (SE) zur ersten und dritten Fläche (F1,F3) bildet und somit für eine zweite Einbaulage (E2), in welcher die Unterseite (US) vertikal ausgerichtet ist, es dem Kühlmedium (KM) möglich ist jeweils über die übereinander angeordneten schiefen Ebenen (SE) zu strömen.

## Beschreibung

Die Erfindung betrifft ein Automatisierungsgerät ausgestaltet für den Einsatz in einem Automatisierungsumfeld zur Automatisierung eines industriellen Prozesses, aufweisend ein Grundgehäuse umfassend eine Rückseite eine Oberseite, eine Unterseite, ein erstes Seitenteil und ein zweites Seitenteil, wodurch eine Kastenform gegeben ist, die Rückseite ist zur Montage an einem Montagemittel ausgestaltet, eine Leiterplatte ist parallel zu dem ersten Seitenteil und dem zweiten Seitenteil rechtwinklig zu der Oberseite bzw. der Unterseite angeordnet, die Leiterplatte trägt einen Mikroprozessor, welcher wiederum mit einem Kühlkörper in thermischer Verbindung steht, wobei der Kühlkörper Kühlbleche aufweist.

Die EP 2 736 311 B1 offenbart ein Automatisierungsgerät aufweisend ein Grundgehäuse, eine Fronthaube, einen Hauptkühlkörper zum Abführen von Wärme eines Mikroprozessors.

Aufgrund einer Miniaturisierung von Elektronikkomponenten, wird zunehmend eine höhere Packungsdichte/Funktionsdichte an elektronischen Komponenten/Bauteilen auf einer Flachbaugruppe, wie beispielsweise einer bestückten Leiterplatte, realisiert. Dies führt zu einer Erhöhung der Verlustleistung, insbesondere bei Mikroprozessoren, da die Leistungsfähigkeit von Mikroprozessoren zunehmend steigt und damit auch eine Verlustwärme steigt. Der Einsatz von beispielsweise modernen Mikroprozessoren, wie sie für die Personal Computer Welt eingesetzt werden, in einem Automatisierungsgerät führt zu einem enormen Anstieg der Verlustleistung in dem Automatisierungsgerät.

Bei üblichen, bisherigen CPUen im gesamten Industriebereich wurden bisher Prozessoren mit geringerer Leistungsdichte verbaut. Daher waren als "State of the Art" bisher Kühlkörper aus Druckguss- oder Strangpressteilen ausreichend. Durch die wesentlich höhere Leistungsdichte der neuen Prozessor-Generationen wäre ein solcher Kühlkörper, bei den in der Industrie geforderten Umgebungsbedingungen, wie beispielsweise Temperaturen bis 60°C, keine aktiven Lüfter nutzen, sondern nur auf Konvektions-Kühlung zurückzugreifen, Schwing- und Schock-Beanspruchung und sehr langer Dauerbetrieb bis zu 10 Jahren, durch seine geringere Kühlleistung nicht ausreichend. Daher muss hier zukünftig ein neuartiges, wesentlich leistungsfähigeres Kühlsystem eingesetzt werden. Weiterhin soll eine ausreichende Kühlung unabhängig von einer Einbaulage gewährleistet sein.

Es ist eine Aufgabe der vorliegenden Erfindung ein verbessertes Kühlkonzept für Automatisierungsgeräte bereitzustellen, welches eine ausreichende Kühlung unabhängig von einer Einbaulage gewährleistet.

Die Aufgabe wird dadurch gelöst, dass der Kühlkörper eine Mehrzahl an Kühlblechen aufweist, welche parallel zur Leiterplatte mit jeweils einem Zwischenraum zueinander angeordnet sind und somit für eine erste Einbaulage, in welcher die Unterseite waagerecht ausgerichtet ist, es einem Kühlmedium möglich ist von der Unterseite durch die Zwischenräume zu strömen, das die Kühlbleche eine erste Fläche, eine zweite Fläche und eine dritte Fläche aufweisen, dabei ist die zweite Fläche zwischen der ersten und der dritten Fläche derart angeordnet, das die zweite Fläche eine schiefe Ebene zur ersten und dritten Fläche bildet und somit für eine zweite Einbaulage, in welcher die Unterseite vertikal ausgerichtet ist, es dem Kühlmedium möglich ist jeweils über die übereinander angeordneten schiefen Ebenen zu strömen.

Eine durchgehend geneigte "Rampe" in den Kühlblechen sorgt nun für einen schrägen Kamin-Effekt und damit für eine bessere Kühlmittel-Strömung in der zweiten Einbaulage.

Aufgewärmte Luft kann gemäß dem Kamin Effekt gut abströmen, es wird der Auftrieb warmer Luft ausgenutzt.

Die Rückseite ist zur Montage an einem Montagemittel zum Beispiel einer Schalttafel oder auf einer Standard-Hutschiene ausgestaltet. Eine übliche erste Einbaulage ist eine waagerechte Einbaulage, aber in einigen Fällen kann aufgrund von Platzmangel eine zweite Einbaulage, also eine um 90°C zur ersten Einbaulage gedrehte Einbaulage gefordert sein.

Beispielsweise ist der Temperaturbereich für Automatisierungsbaugruppen von 0°C bis +60°C ausgelegt, aber bei einer senkrechten Einbaulage sollten 40°C nicht überschritten werden.

Der schräge Strömung-Effekt über die jetzt vorhandenen schrägen Rampen wirkt sich nochmals positiv auf den Wirkungsgrad einer evtl. eingesetzten Heatpipe im vertikalen Fall aus. Eine positive Folge daraus ist, dass eine Kühl-Performance bei Einsatz einer Heatpipe auch im waagerechten Einbau nahezu konstant bleibt.

Wird eine Heatpipe eingesetzt umfasst der Kühlkörper eine Kühlplatte, welche auf dem Mikroprozessor angeordnet ist, in die Kühlplatte ist eine Röhre derart eingelassen, dass ein erster Röhrenabschnitt senkrecht aus der Kühlplatte heraussteht, ein zweiter Röhrenabschnitt zumindest teilweise in die Kühlplatte eingelassen ist und ein dritter Röhrenabschnitt wiederum senkrecht aus der Kühlplatte heraussteht, die Kühlbleche sind am ersten Röhrenabschnitt und am dritten Röhrenabschnitt parallel zur Leiterplatte mit jeweils einem Zwischenraum zueinander angeordnet.

Die Kühlleistung wird noch weiter verbessert, wenn in die Kühlplatte eine erste Röhre und eine zweite Röhre derart eingelassen sind, dass ein erster Röhrenabschnitt der ersten Röhre senkrecht aus der Kühlplatte heraussteht, ein zweiter Röhrenabschnitt der ersten Röhre zumindest teilweise in die Kühlplatte eingelassen ist und ein dritter Röhrenabschnitt der ersten Röhre wiederum senkrecht aus der Kühlplatte heraussteht, unddass ein erster Röhrenabschnitt der zweiten Röhre senkrecht aus der Kühlplatte heraussteht, ein zweiter Röhrenabschnitt der zweiten Röhre zumindest teilweise in die Kühlplatte eingelassen ist und ein dritter Röhrenabschnitt der zweiten Röhre wiederum senkrecht aus der Kühlplatte heraussteht, die Kühlbleche sind am ersten Röhrenabschnitt und am dritten Röhrenabschnitt der jeweiligen ersten und zweiten Röhre parallel zur Leiterplatte mit jeweils einem Zwischenraum zueinander angeordnet.

Es können zum Beispiel zwei Kupfer-Rohre, als sogenannte "Heatpipes" die in die Kühlplatte, welche als ein Heatspreader wirkt, entweder gepresst, geklebt oder gelötet werden. Die Kühlbleche beispielsweise aus Aluminium, können auch auf die Heatpipes entweder gepresst, geklebt oder gelötet werden.

Damit auch bei einer Vibrationsbeanspruchung des Automatisierungsgerätes der Kontakt des zu kühlenden Microprozessors zur Kühlplatte nicht verloren geht ist die Kühlplatte von einem Basisträger umgeben, an dem Basisträger ist ein Deckel angeordnet und zwischen dem Basisträger und dem Deckel ist die Leiterplatte angeordnet, wobei zwischen Deckel und Leiterplatte ein federnd gelagertes Anpressmittel angeordnet ist.

Um eine stabile Anordnung eines Kühlpaketes zu erhalten sind die Kühlbleche als Blechstanzteile ausgestaltet und im Randbereich sind Verbindungslaschen angeordnet, wobei eine Verbindungslasche ein Stützteil, einen ersten Schenkel und einen zweiten Schenkel umfasst, der erste Schenkel und der zweite Schenkel sind am Rand des Kühlblechs angeordnet, wobei sich der erste und zweite Schenkel zu dem Stützteil vereinigen, zwischen dem ersten Schenkel und dem zweiten Schenkel ist eine Ausnehmung derart ausgestanzt, das ein Zapfen am Rand angeordnet ist, wobei zusätzlich durch die Ausnehmung an der Verbindungsstelle des ersten und zweiten Schenkels zu dem Stützteil ein Zapfenlager angeordnet ist. Die Verbindungslaschen sind um 90 Grad zur Flächennormalen des Kühlbleches abgewinkelt, so wird es möglich ein Paket aus Kühlblechen zu bilden. Die Kühlbleche sind jetzt stapelbar und verklemmen bzw. verrasten miteinander.

Im Sinne der Erfindung ist unter Heatpipe also den eingesetzten Röhren ein Kühlungssystem zu verstehen, dass in Form eines geschlossenen Systems in Wärmerohren die Kühlung eines Microprozessors bewirkt. Die meisten Heatpipes funktionieren nach einem einfachen Schema: Das dünnwandige Wärmerohr besitzt innen eine spezielle Kapillarstruktur und ist aus thermisch hochleitfähigem Material hergestellt. Es verfügt über eine kleine Menge verdampfbarer Flüssigkeit. Durch das Prinzip der Röhrenkühlung nimmt eine Heatpipe höhere Temperaturen auf und transportiert diese an eine Stelle, an der es die Wärme abbauen kann.

Im Inneren des Wärmerohrs herrscht Unterdruck und es befindet sich etwas Flüssigkeit. Diese nimmt die Wärme auf, erhitzt sich und wandert in Dampfform an das andere Ende des Heatpipes. Dabei wird sie aufgrund der dort herrschenden niedrigen Temperatur abkühlt und somit kondensiert. Hierdurch wird die Wärme abgegeben, wobei die Flüssigkeit wieder kalt wird. Anschließend fließt sie wieder an ihrem eigentlichen Ort für die Wärmeaufnahme zurück und macht sich für eine neue Runde startbereit.

Die Zeichnung zeigt ein Ausführungsbeispiel der Erfindung. Dabei zeigt:
- FIG 1: ein Automatisierungsgerät in einer dreidimensionalen Ansicht,
- FIG 2: das Automatisierungsgerät mit Blick auf eine Vorderseite,
- FIG 3: das Automatisierungsgerät aus FIG 2 in einer um 90 Grad gedrehten Einbaulage,
- FIG 4: das Automatisierungsgerät mit Blick auf eine Seitenansicht,
- FIG 5: das Automatisierungsgerät mit einem teilgeöffneten Gehäuse mit Blick auf einen Kühlkörper,
- FIG 6: das Automatisierungsgerät mit Blick auf eine Leiterplatte und einen Mikroprozessor,
- FIG 7: eine Kühlkörpereinheit mit einem Kühlblechpaket,
- FIG 8: ein Kühlblech,
- FIG 9: die Kühleinheit mit Blick auf eine Kühlplatte und eine Darstellung von Heatpipes,
- FIG 10: die Kühleinheit aus FIG 9 in einer gedrehten Darstellung mit Blick auf einen Deckel,
- FIG 11: die Kühleinheit mit geöffnetem Deckel mit Blick auf ein Anpresselement,
- FIG 12: ein Anpresselement,
- FIG 13A, FIG13B: das Kühlblechpaket für das Automatisierungsgerät einmal in einer waagerechten Einbaulage und einmal in einer senkrechten Einbaulage,
- FIG 14: eine Detaildarstellung der Kühlbleche mit ineinander gehakten Verbindungslaschen,
- FIG 15: eine Detaildarstellung einer Verbindungslasche,
- FIG 16: das Kühlblech aus FIG 9 in einer Schnittdarstellung und
- FIG 17: das Kühlblech in einer Abwicklung.

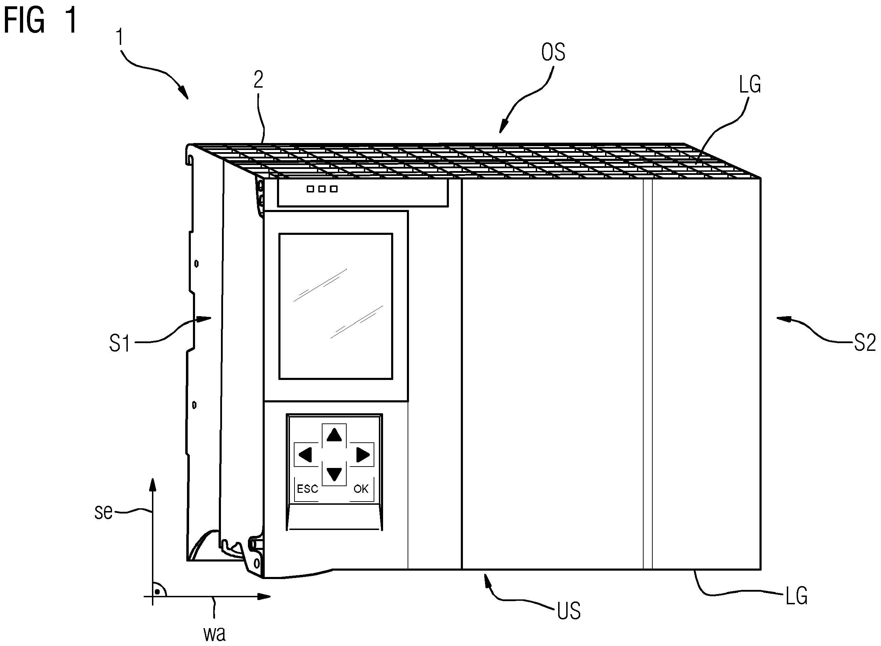

Gemäß FIG 1 ist ein Automatisierungsgerät 1 für den Einsatz in einem Automatisierungsumfeld zur Automatisierung eines industriellen Prozesses dargestellt.

Das Automatisierungsgerät 1 weist ein Grundgehäuse 2 umfassend eine Rückseite RS, eine Oberseite OS, eine Unterseite US, ein erstes Seitenteil S1 und ein zweites Seitenteil S2 auf. Dadurch ist für das Automatisierungsgerät 1 eine Kastenform gegeben, in welcher die im Inneren befindlichen elektronischen Schaltungen, Leiterplatte, Kühlelemente, Anschlüsse usw. angeordnet sind. Auf der Oberseite OS und der Unterseite US weist das Automatisierungsgerät 1 Lüftungsgitter LG auf. Für eine Standardeinbaulage ist das Automatisierungsgerät 1 waagerecht WA ausgerichtet. Das bedeutet, die Seitenteile S1,S2 sind senkrecht ausgerichtet. Das Automatisierungsgerät 1 ist hinsichtlich seines Kühlprinzips auf eine Konvektions-kühlung ausgelegt, das bedeutet, dass von der Unterseite US her Luft einströmen kann, die Baugruppe kühlen kann und an der Oberseite OS über das Lüftungsgitter LG wiederum austritt.

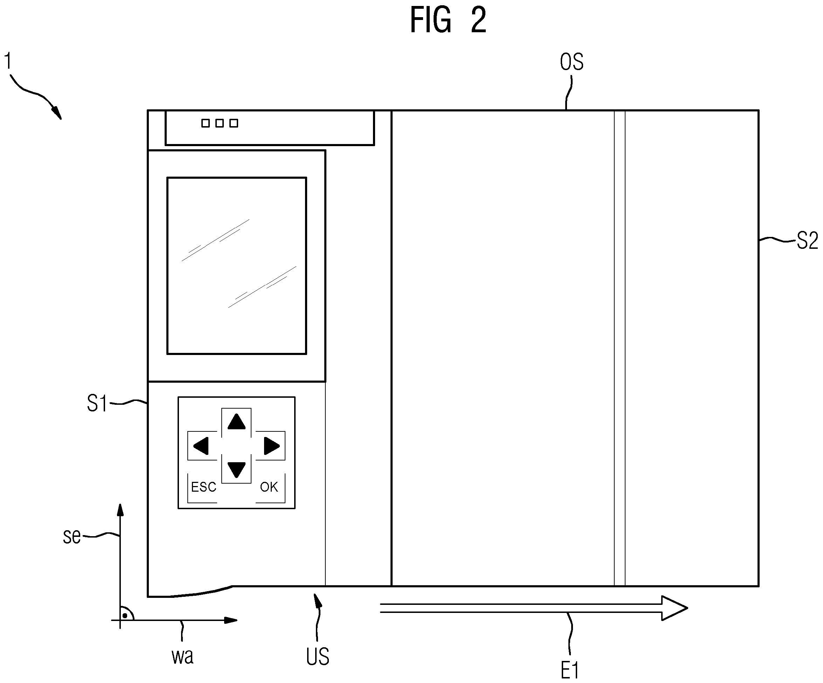

Die FIG 2 zeigt das Automatisierungsgerät 1 in einer ersten Einbaulage E1, die erste Einbaulage E1 ist für das Automatisierungsgerät 1 eine Vorzugseinbaulage. Die Unterseite US ist waagerecht WA ausgerichtet.

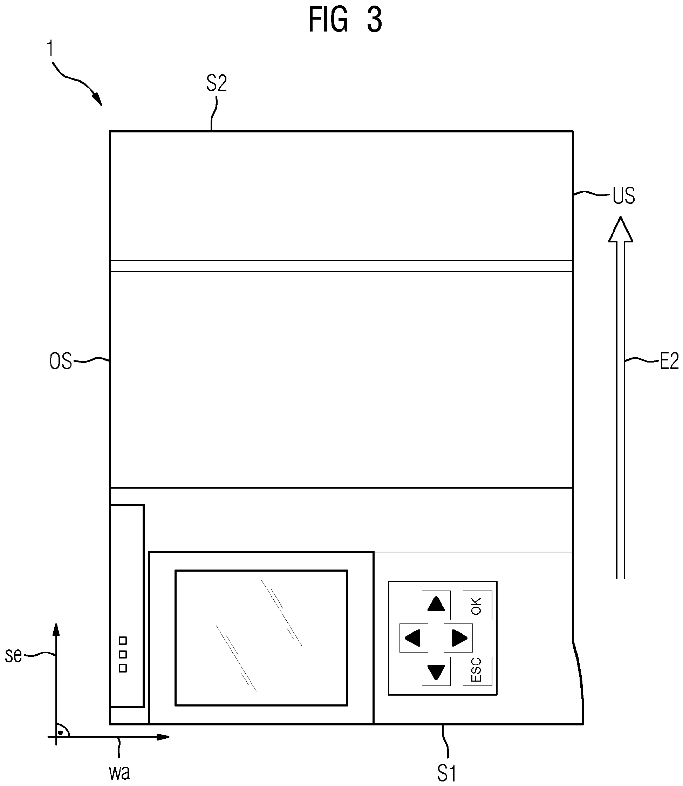

Die FIG 3 zeigt das Automatisierungsgerät 1 in einer zweiten Einbaulage E2 dabei sind die Seitenteile S1,S2 waagerecht WA und die Oberseite OS bzw. die Unterseite US sind senkrecht SE ausgerichtet.

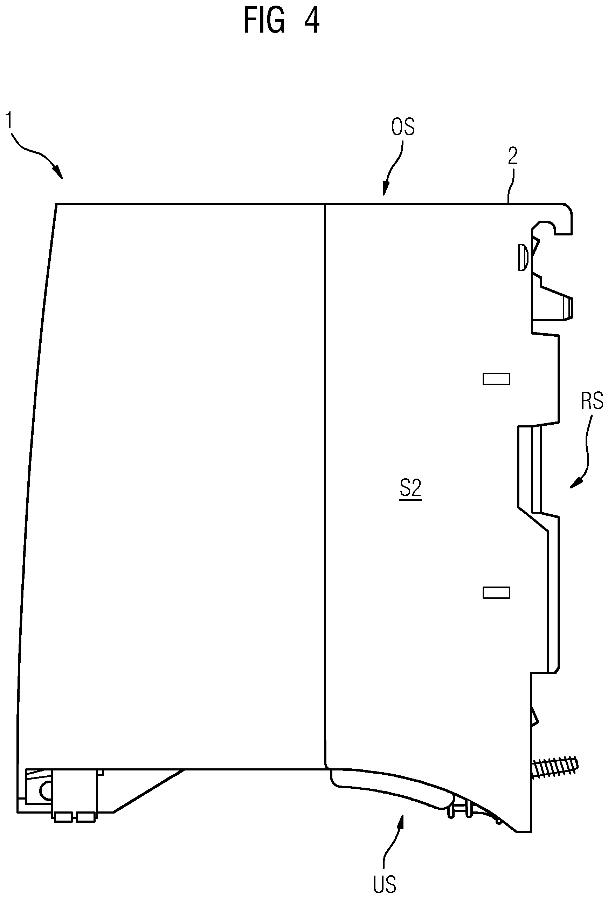

Gemäß FIG 4 ist das Automatisierungsgerät 1 mit Blick auf das zweite Seitenteil S2 dargestellt. Die Rückseite RS ist zur Montage an einem Montagemittel ausgestaltet. Hier befinden sich beispielsweise ein Haken um das Automatisierungsgerät 1 auf einer Profilschiene aufzuhaken, es befindet sich eine Massefeder um einen Massekontakt zur Profilschiene herzustellen und es befindet sich ein Schraubmittel für eine endgültige Befestigung.

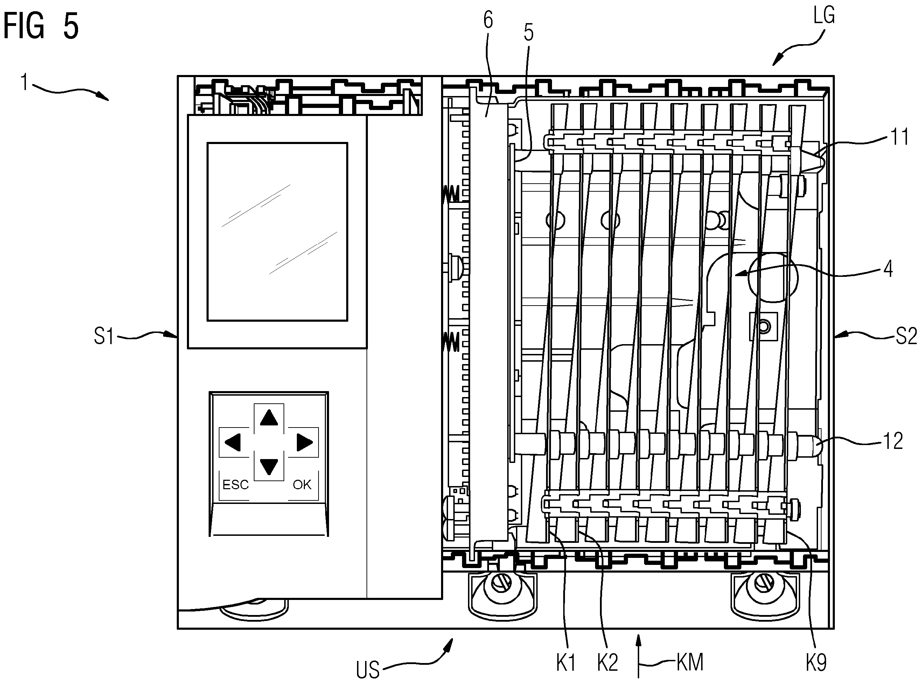

Gemäß FIG 5 ist das Automatisierungsgerät 1 teilweise von einer Fronthaube befreit und man erhält Blick auf einen Kühlkörper 4. Der Kühlkörper 4 steht in thermischer Verbindung mit einen auf einer Leiterplatte L angeordneten Mikroprozessor 3. Der Kühlkörper 4 weist eine Mehrzahl an Kühlblechen K1,...,K9 auf. Die Kühlbleche K1,...,K9 sind parallel zur Leiterplatte L mit jeweils einem Zwischenraum zueinander angeordnet und somit für die erste Einbaulage E1, in welcher die Unterseite US waagerecht WA ausgerichtet ist, es einen Kühlmedium KM möglich ist, von der Unterseite US durch die Zwischenräume zu strömen und das Automatisierungsgerät 1 zu entwärmen. In dem Kühlkörper 4 ist zur effektiven Entwärmung der Kühlplatte 5, welche direkt auf den Mikroprozessor 3 aufliegt, eine Heatpipe vorgesehen. Die Heatpipe umfasst eine erste Röhre 11 und eine zweite Röhre 12.

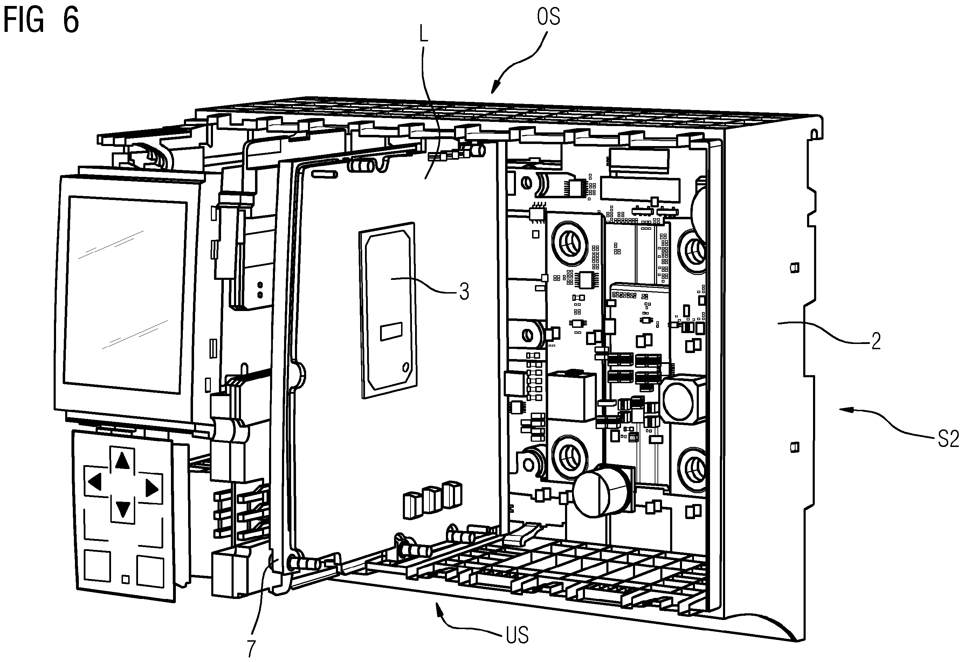

Dabei zeigt die FIG 6 das Automatisierungsgerät 1 in einer dreidimensionalen Ansicht mit entferntem Kühlkörper 4. Damit wird der Blick auf die Leiterplatte L und dem darauf verbauten Mikroprozessor 3 offengelegt. Bei herkömmlichen Prozessoren betrug bisher die Verlustleistung 5 bis 12 Watt. Nun sollen aber neue Prozessoren nach einem 10 nm-Herstellungsprozess zum Einsatz kommen. Diese Mikroprozessoren erreichen eine wesentlich höhere Taktfrequenz und damit auch eine wesentlich höhere Verlustleistung, welche effektiv abgeführt werden muss. Ein neuartiger Mikroprozessor 3 erreicht beispielsweise bei einem Turbofrequenzbetrieb eine Verlustleistung von nahezu 50 Watt.

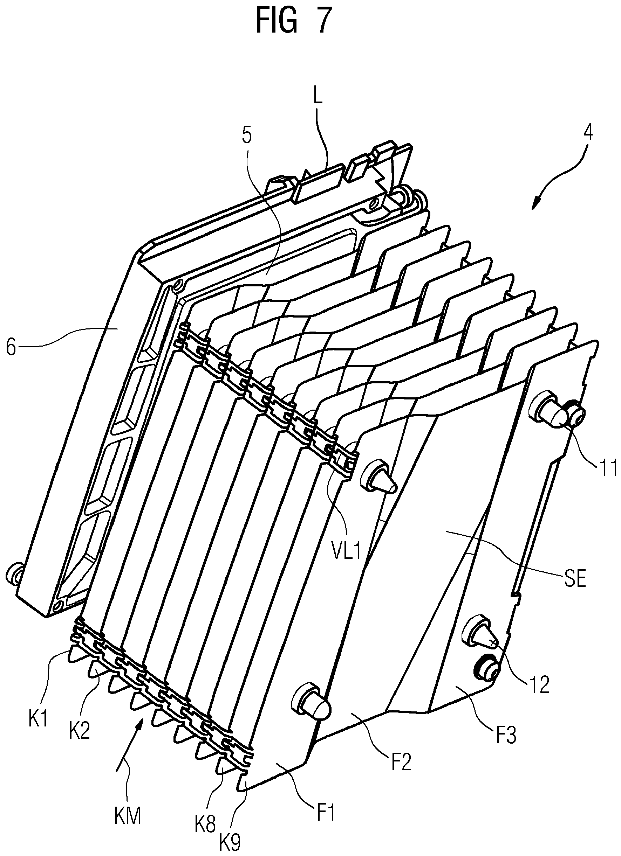

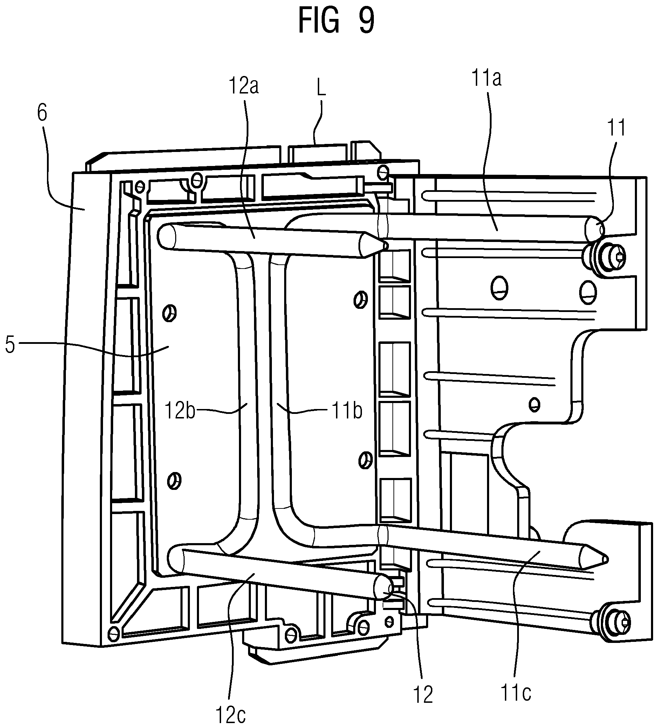

Gemäß FIG 7 ist der Kühlkörper 4 in einer dreidimensionalen Ansicht dargestellt. Der Kühlkörper 4 ist auf der Kühlplatte 5 angeordnet. Die Kühlplatte 5 ist wiederum direkt auf dem Mikroprozessor 3 angeordnet. In die Kühlplatte 5 ist eine erste Röhre 11 und eine zweite Röhre 12 (siehe FIG 9) angeordnet. Der Kühlkörper 4 umfasst eine Mehrzahl von Kühlblechen K1,...,K9, welche parallel zur Leiterplatte L jeweils mit einem Zwischenraum zueinander angeordnet sind und somit es einem Kühlmedium KM möglich ist, von der Unterseite US zwischen die Kühlbleche K1,...,K9 einzuströmen.

In den Kühlblechen K1,...,K9 sind durchgehend geneigte Rampen angeordnet, um hierdurch einen schrägen Kamin-Effekt hervorzurufen. Es wird eine bessere Luftströmung erreicht, insbesondere in der Anordnung, wenn die Heatpipe vertikal nach oben ausgerichtet ist. Die durchgängige Rampe in den Kühlblechen wird dadurch erreicht, dass die Kühlbleche K1,...,K9 eine erste Fläche F1, eine zweite Fläche F2 und eine dritte Fläche F3 aufweisen. Die zweite Fläche F2 ist zwischen der ersten und der dritten Fläche F1,F3 derart angeordnet, dass die zweite Fläche F2 eine schiefe Ebene SE zur ersten und dritten Fläche F1,F3 bildet. Durch diese Anordnung ist für die zweite Einbaulage E2, in welcher die Unterseite US vertikal ausgerichtet ist, es dem Kühlmedium KM möglich, jeweils über die übereinander angeordneten schiefen Ebenen SE zu strömen. Die aufgewärmte Luft, beispielsweise kann gemäß dem Kamineffekt gut abströmen. Es wird der Auftrieb warmer Luft in Strömungsrichtung über die Schräge ausgenutzt.

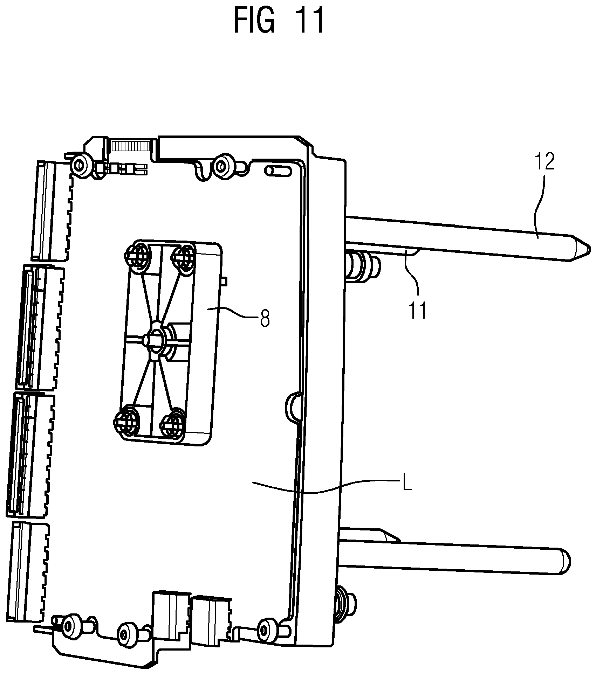

Die Kühlplatte 5 ist von einem Basisträger 6 umgeben. An dem Basisträger 6 ist ein Deckel 7 angeordnet (siehe FIG 6) und zwischen dem Basisträger 6 und dem Deckel 7 ist die Leiterplatte L angeordnet. Ein federgelagertes Anpressmittel 8 ist zwischen dem Deckel 7 und der Leiterplatte L angeordnet (siehe FIG 11).

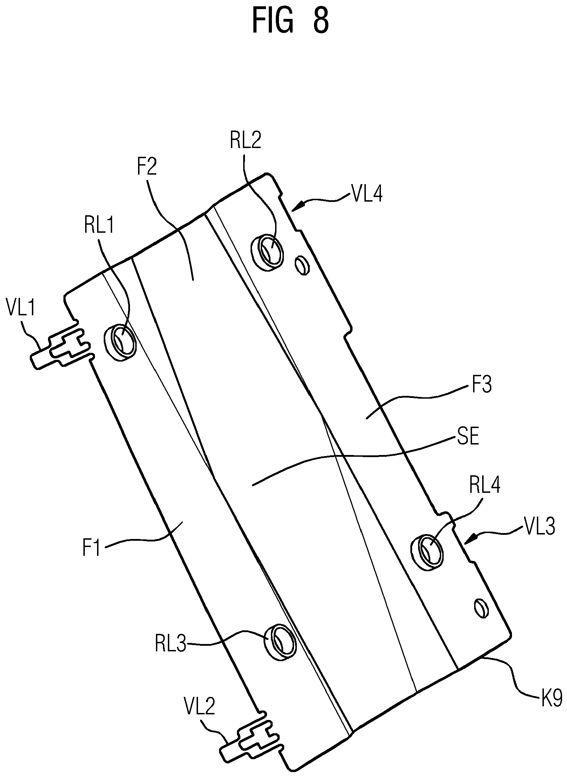

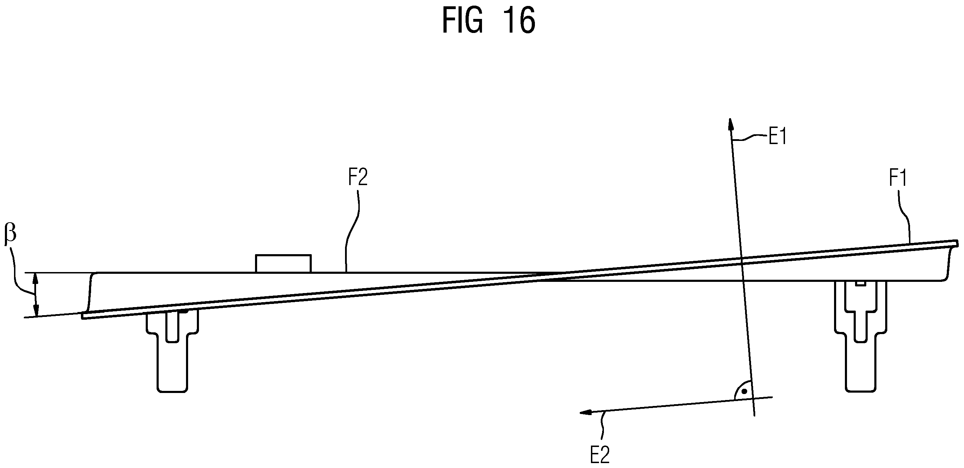

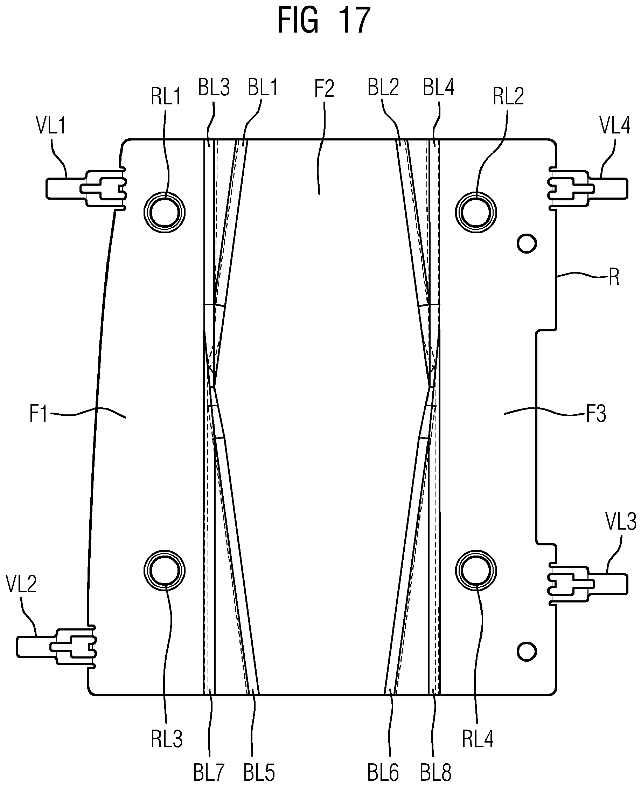

Gemäß FIG 8 ist ein einzelnes Kühlblech am Beispiel des neunten Kühlbleches K9 dargestellt. Das Kühlblech mit der ersten Fläche F1, der zweiten Fläche F2 und der dritten Fläche F3, wobei die zweite Fläche F2 eine schiefe Ebene SE bildet, ist aus einem flachen Blechstanzteil entstanden. Bezüglich des flachen Blechstanzteils (siehe FIG 16 und FIG 17). Die zweite Fläche F2 ist zwischen der ersten und der dritten Fläche F1,F3 derart angeordnet, dass die zweite Fläche F2 die schiefe Ebene SE zur ersten und dritten Fläche F1,F3 bildet. Diese schiefe Ebene SE wird für die zweite Einbaulage E2 für eine vorteilhafte Luftströmung verwendet. Denn, wenn die Unterseite US vertikal ausgerichtet ist, ist es dem Kühlmedium KM nun möglich, jeweils über die übereinander angeordneten schiefen Ebenen SE zu strömen.

Die FIG 16 zeigt dabei einen Querschnitt durch das Kühlblech aus FIG 8. Der Schnitt geht durch die erste Fläche F1 und erlaubt somit einen Blick auf die sich schräg nach oben bzw. schräg nach links verlaufende schräge Ebene SE der zweiten Fläche F2. Die zweite Fläche F2 weist zur ersten Fläche F1 einen Rampenwinkel β von ca. 4,5 Grad auf. In der ersten Einbaulage E1 steht das Kühlblech senkrecht zur ersten Einbaulage E1 und in der zweiten Einbaulage E2 liegt das Kühlblech waagerecht, so dass über die entstandene Rampe die Kühlluft abströmen kann.

Gemäß FIG 17 ist das Kühlblech als eine Abwicklung des gestanzten Blechstanzteils dargestellt. In dem Randbereich des Blechstanzteils sind die Verbindungslaschen zu erkennen. Zwischen der ersten Fläche F1 und der dritten Fläche F3 ist die zweite Fläche F2 durch Biegelinien BL1,...,BL8 abgegrenzt. Das Blechstanzteil wird derart gebogen, dass die erste Biegelinie BL1 mit der dritten Biegelinie BL3 eine nach oben stehende Erhöhung bildet. Dasselbe gilt für die gegenüberliegende Seite der ersten Biegelinie BL1 und der dritten Biegelinie BL3. Hier sind die zweite Biegelinie BL2 und die vierte Biegelinie BL4 zu erkennen. Auch hier wird das Blechstanzteil derart gebogen, dass die zweite Biegelinie BL2 nach einem Biegevorgang über der vierten Biegelinie BL4 steht. Für die fünfte Biegelinien BL5 und die sechste Biegelinie BL6 gilt, dass sie derart nach unten gebogen werden, also entgegengesetzt der Richtung zu den oberen Biegelinien, dass im Zusammenspiel die fünfte Biegelinie BL5 und die siebte Biegelinie BL7 bzw. die sechste Biegelinie BL6 und die achte Biegelinie BL8 eine nach unten geneigte Rampe bilden. Im Ganzen wird eine schräg nach oben verlaufende Rampe durch die Biegevorgänge in dem Blechstanzteil erreicht.

Das neunte Kühlblech K9 ist als ein Blechstanzteil aus Aluminium ausgestaltet und weist im Randbereich an dem Rand R die Verbindungslaschen VL1,...,VL4 auf. Für das Aufstecken auf die erste Röhre 11 bzw. die zweite Röhre 12 weist das Kühlblech K9 ein erstes Rohrloch RL1, ein zweites Rohrloch RL2, ein drittes Rohrloch RL3 und ein viertes Rohrloch RL4 auf.

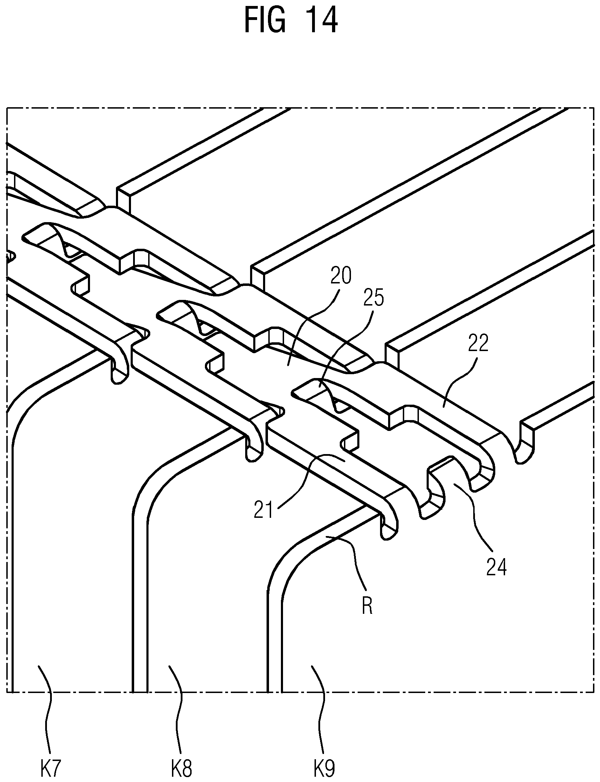

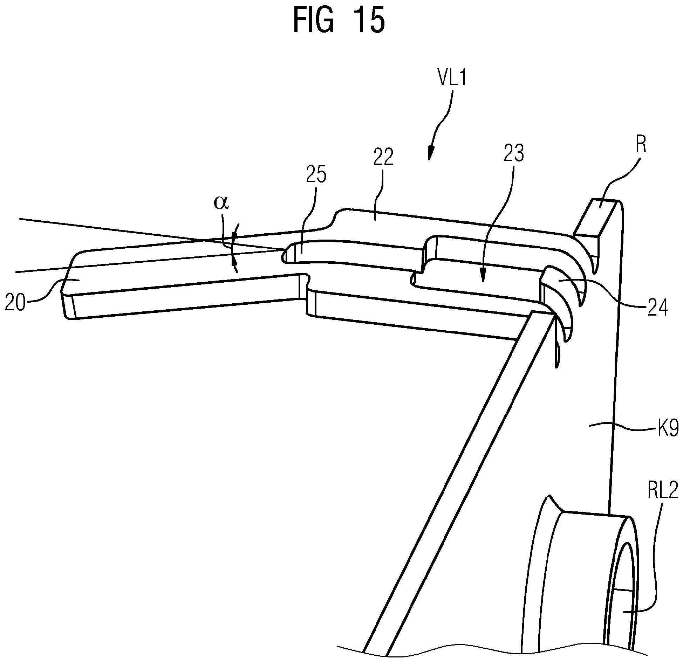

In den Figuren 14 und 15 werden später die Verbindungslaschen VL1,...,VL4 im Detail erklärt und es wird ersichtlich, wie aufgrund der Konstruktion der Verbindungslaschen VL1,...,VL4 es möglich wird aus den einzelnen Kühlblechen K1,...,K9 einen stapelbaren fest miteinander verbundenen Kühlkörper 4 zu erstellen.

Mit der FIG 9 wird das Einlassen der ersten Röhre 11 und der zweiten Röhre 12 in die Kühlplatte 5 veranschaulicht. In die Kühlplatte 5 ist die erste Röhre 11 und die zweite Röhre 12 derart eingelassen, dass ein erster Röhrenabschnitt 11a der ersten Röhre 11 senkrecht aus der Kühlplatte 5 heraussteht. Ein zweiter Röhrenabschnitt 11b der ersten Röhre 11 ist zumindest teilweise in die Kühlplatte 5 eingelassen. Ein dritter Röhrenabschnitt 11c der ersten Röhre 11 steht wiederum senkrecht aus der Kühlplatte 5 heraus. Ebenso ist die zweite Röhre 12 angeordnet. Ein erster Röhrenabschnitt 12a der zweiten Röhre 12 steht senkrecht aus der Kühlplatte 5 heraus, ein zweiter Röhrenabschnitt 12b der zweiten Röhre 12 ist zumindest teilweise in die Kühlplatte 5 eingelassen. Ein dritter Röhrenabschnitt 12c der zweiten Röhre 12 steht wiederum senkrecht aus der Kühlplatte 5 heraus. Durch diese Anordnung der ersten Röhre 11 und der zweiten Röhre 12 können die Kühlbleche K1,...,K9 auf die senkrecht herausstehenden Röhrenabschnitte aufgestapelt werden und mit den Verbindungslaschen VL1,...,VL4 miteinander zu einem Kühlkörperpaket verbunden werden.

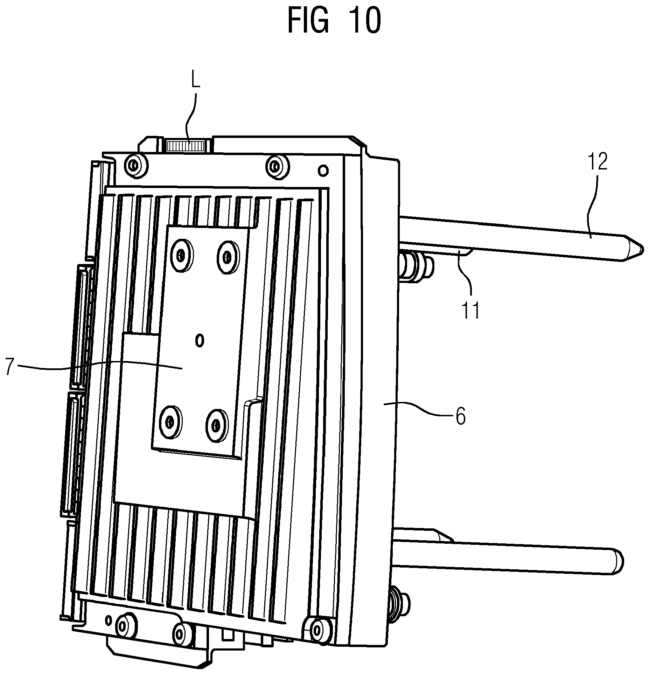

Die FIG 10 zeigt den auf den Basisträger 6 aufgeschraubten Deckel 7 unter der ausgeprägten Erhöhung im Deckel 7 befindet sich das Anpressmittel 8.

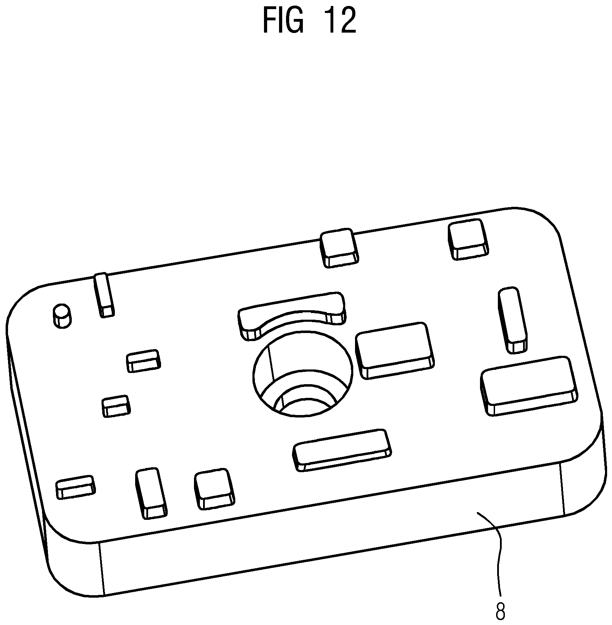

Mit der FIG 11 ist der Deckel 7 geöffnet und es wird das federnd gelagerte Anpressmittel 8 sichtbar. Das Anpressmittel 8 ist gemäß FIG 12 ausgestaltet, in dem Deckel 7 federnd gelagert die Leiterplatte L über bestimmte angeordnete Dohme und Stege in dem Anpressmittel 8 gezielt auf die Kühlplatte 5 aufzudrücken, so dass der Mikroprozessor 3 immer guten Kontakt zur Kühlplatte 5 hat.

Das Anpressmittel 8 ist aus einem Kunststoff mit der Kurzbezeichnung PEEK 10GF, Polyetheretherketon mit 10%iger Glasfaserverstärkung, gefertigt. Dieser Werkstoff ermöglicht den Einsatz bei Dauergebrauchstemperaturen von bis zu 250-260°C.

Das Anpressmittel 8 ist als ein Andruckstempel mit speziell angeordneten Domen ausgestaltet, welche in die Lücken der Bestückung direkt auf die Leiterplatte L drücken. Dadurch wird die Leiterplatte L, mit auf der Gegenüberseite der Leiterplatte L bestückten Mikroprozessor 3, mit einer definierten Kraft von vier Andruckfedern auf die Kühlplatte 5 der Heatpipe gepresst, ohne elektronische Bauteile zu schädigen.

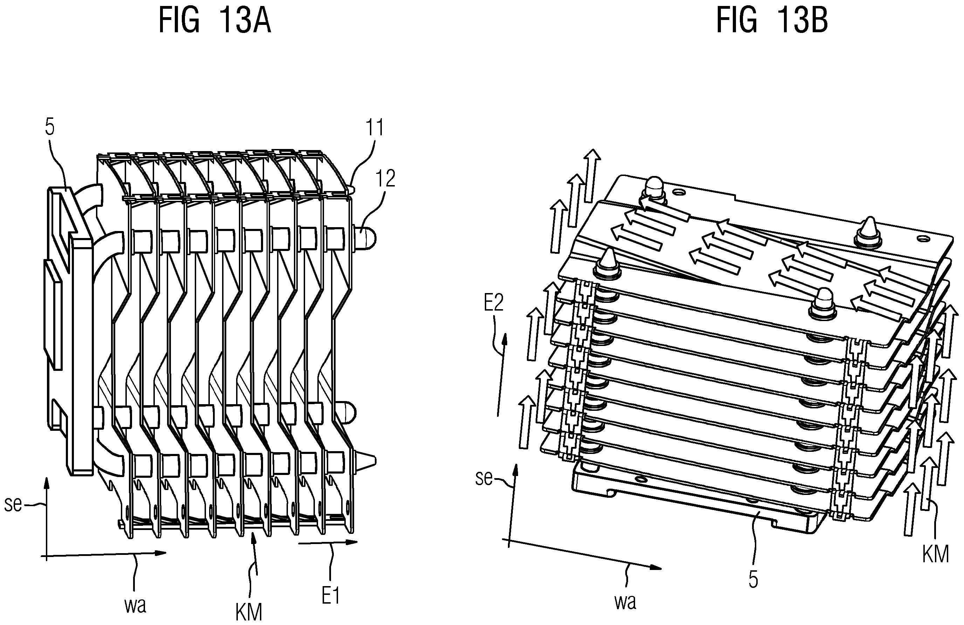

Die Figuren 13A und 13B verdeutlichen noch einmal das erfindungsgemäße Prinzip eines Kühlkörpers 4, welcher für eine erste Einbaulage E1 und eine zweite Einbaulage E2 die ausreichende Entwärmung der Baugruppe sicherstellt.

Gemäß FIG 13A kann in der ersten Einbaulage E1 ein Kühlmedium KM durch die Zwischenräume der Kühlbleche K1,...,K9 strömen. In der zweiten Einbaulage E2 gemäß FIG 13B befindet sich die Kühlplatte 5 in einer waagerechten WA Position. Jetzt ist es möglich, durch die übereinander angeordneten schrägen Ebenen SE, dass das Kühlmedium KM durch eine Kaminwirkung besser durch den Kühlkörper 4 strömt.

Die FIG 14 und FIG 15 zeigen das konstruktive Prinzip der Verbindungslaschen VL1,...,VL4. Gemäß FIG 14 ist ein Detailausschnitt des Kühlkörpers 4 dargestellt. Das siebte Kühlblech K7 ist unter dem achten Kühlblech K8 und unter dem neunten Kühlblech K9 angeordnet. Im Randbereich am Rand R des neunten Kühlbleches K9 sind die Verbindungslaschen VL1,...,VL4 aus dem Blechteil derart ausgestanzt, dass sich für eine Verbindungslasche VL1 folgende Anordnung ergibt. Ein Stützteil 20 ist mit einem ersten Schenkel 21 und einem zweiten Schenkel 22 verbunden. Der erste Schenkel 21 und der zweite Schenkel 22 sind am Rand R des Kühlbleches K1,...,K9 angeordnet. Der erste und zweite Schenkel 21,22 vereinigen sich zu dem Stützteil 20. Zwischen dem ersten Schenkel 21 und dem zweiten Schenkel 22 ist eine Ausnehmung derart ausgestanzt, dass ein Zapfen 24 am Rand R angeordnet ist. Das Gegenstück für den Zapfen 24 befindet sich zusätzlich durch die Ausnehmung 23 an der Verbindungsstelle des ersten und zweiten Schenkels 21,22 zu dem Stützteil 20 ist ein Zapfenlager 25 angeordnet. Ein jeweiliger Zapfen 24 des einzuhakenden Bleches greift in das Zapfenlager 25 des darüberliegenden Kühlbleches K1,...,K9 ein.

Das Stützteil 20 sorgt nicht nur für eine bessere Festigkeit sondern definiert den Abstand für die Zwischenräume zwischen den Kühlblechen K1,...,K9. Das Blechteil als ausgestanztes Aluminiumblechteil wird noch einmal mit FIG 15 verdeutlicht. Die ausgestanzte Verbindungslasche VL1 wird nahezu rechtwinklig von dem Kühlblech K9 abgebogen. Weiterhin ist das Stützteil 20 noch einmal um einen Biegewinkel α von dem ersten Schenkel 21 und dem zweiten Schenkel 22 abgebogen. Damit das Stützteil 20 auf dem darunterliegenden Kühlblech 20 sicher aufliegt. Das dargestellte zweite Rohrloch L2 ist mit einer Ausprägung auch durch einen Stanzvorgang aus dem Kühlblech K9 ausgestanzt. Durch diese Art der Ausstanzung lassen sich später die erste Röhre 11 bzw. die zweite Röhre 12 besser einkleben, verlöten oder verpressen.

Mit dargestellten Verbindungslaschen VL1,...,VL4 kann ein Kühlkörper 4 beliebig hoch gestapelt werden und hat immer eine ausreichende Festigkeit und erhält immer den gleichen Zwischenraum.

## Patentansprüche

1. Automatisierungsgerät (1) ausgestaltet für den Einsatz in einem Automatisierungsumfeld zur Automatisierung eines industriellen Prozesses, aufweisend
ein Grundgehäuse (2) umfassend eine Rückseite (RS) eine Oberseite (OS), eine Unterseite (US), ein erstes Seitenteil (S1) und ein zweites Seitenteil (S2), wodurch eine Kastenform gegeben ist, die Rückseite (RS) ist zur Montage an einem Montagemittel ausgestaltet, eine Leiterplatte (L) ist parallel zu dem ersten Seitenteil (S1) und dem zweiten Seitenteil (S2) rechtwinklig zu der Oberseite (OS) bzw. der Unterseite (US) angeordnet, die Leiterplatte (L) trägt einen Mikroprozessor (3), welcher wiederum mit einem Kühlkörper (4) in thermischer Verbindung steht, der Kühlkörper (4) weist Kühlbleche auf,
**dadurch gekennzeichnet, dass** der Kühlkörper (4) eine Mehrzahl an Kühlblechen (K1,...,K9) aufweist, welche parallel zur Leiterplatte (L) mit jeweils einem Zwischenraum zueinander angeordnet sind und somit für eine erste Einbaulage (E1), in welcher die Unterseite (US) waagerecht ausgerichtet ist, es einem Kühlmedium (KM) möglich ist von der Unterseite (US) durch die Zwischenräume zu strömen, wobei die Kühlbleche (K1,...,K9) eine erste Fläche (F1), eine zweite Fläche (F2) und eine dritte Fläche (F3) aufweisen, dabei ist die zweite Fläche (F2) zwischen der ersten und der dritten Fläche (F1,F3) derart angeordnet, das die zweite Fläche (F2) eine schiefe Ebene (SE) zur ersten und dritten Fläche (F1,F3) bildet und somit für eine zweite Einbaulage (E2), in welcher die Unterseite (US) vertikal ausgerichtet ist, es dem Kühlmedium (KM) möglich ist jeweils über die übereinander angeordneten schiefen Ebenen (SE) zu strömen.

2. Automatisierungsgerät (1) nach Anspruch 1, wobei der Kühlkörper (4) eine Kühlplatte (5) umfasst, welche auf dem Mikroprozessor (3) angeordnet ist, in die Kühlplatte (5) ist eine Röhre derart eingelassen, dass ein erster Röhrenabschnitt (11a) senkrecht aus der Kühlplatte (5) heraussteht, ein zweiter Röhrenabschnitt (11b) zumindest teilweise in die Kühlplatte (5) eingelassen ist und ein dritter Röhrenabschnitt (11c) wiederum senkrecht aus der Kühlplatte (5) heraussteht, die Kühlbleche (K1,...,K9) sind am ersten Röhrenabschnitt (11a) und am dritten Röhrenabschnitt (11c) parallel zur Leiterplatte (L) mit jeweils einem Zwischenraum zueinander angeordnet.

3. Automatisierungsgerät (1) nach Anspruch 1, wobei der Kühlkörper (4) eine Kühlplatte (5) umfasst, welche auf dem Mikroprozessor (3) angeordnet ist, in die Kühlplatte (5) ist eine erste Röhre (11) und eine zweite Röhre (12) derart eingelassen, dass ein erster Röhrenabschnitt (11a) der ersten Röhre (11) senkrecht aus der Kühlplatte (5) heraussteht, ein zweiter Röhrenabschnitt (11b) der ersten Röhre (11) zumindest teilweise in die Kühlplatte (5) eingelassen ist und ein dritter Röhrenabschnitt (11c) der ersten Röhre (11) wiederum senkrecht aus der Kühlplatte (5) heraussteht, und dass ein erster Röhrenabschnitt (12a) der zweiten Röhre (12) senkrecht aus der Kühlplatte (5) heraussteht, ein zweiter Röhrenabschnitt (12b) der zweiten Röhre (12) zumindest teilweise in die Kühlplatte (5) eingelassen ist und ein dritter Röhrenabschnitt (12c) der zweiten Röhre (12) wiederum senkrecht aus der Kühlplatte (5) heraussteht, die Kühlbleche (K1,...,K9) sind am ersten Röhrenabschnitt (11a, 12a) und am dritten Röhrenabschnitt (11c,12c) der jeweiligen ersten und zweiten Röhre (11,12) parallel zur Leiterplatte (L) mit jeweils einem Zwischenraum zueinander angeordnet.

4. Automatisierungsgerät (1) nach einem der Ansprüche 2 oder 2, wobei die Kühlplatte (5) von einem Basisträger (6) umgeben ist, an dem Basisträger (6) ist ein Deckel (7) angeordnet und zwischen dem Basisträger (6) und dem Deckel (7) ist die Leiterplatte (L) angeordnet, wobei zwischen Deckel (7) und Leiterplatte (L) ein federnd gelagertes Anpressmittel (8) angeordnet ist.

5. Automatisierungsgerät (1) nach einem der Ansprüche 1 bis 4, wobei die Kühlbleche (K2,...,K9) als Blechstanzteile ausgestaltet sind und im Randbereich Verbindungslaschen (VL1,...,VL4) angeordnet sind, wobei eine Verbindungslasche (VII) ein Stützteil (20), einen ersten Schenkel (21) und einen zweiten Schenkel (22) umfasst, der erste Schenkel (21) und der zweite Schenkel (22) sind am Rand (R) des Kühlblechs (K2,...,K9) angeordnet, wobei sich der erste und zweite Schenkel (21,22) zu dem Stützteil (20) vereinigen, zwischen dem ersten Schenkel (21) und dem zweiten Schenkel (22) ist eine Ausnehmung (23) derart ausgestanzt, dass ein Zapfen (24) am Rand (R) angeordnet ist, wobei zusätzlich durch die Ausnehmung (23) an der Verbindungsstelle des ersten und zweiten Schenkels (21,22) zu dem Stützteil (20) ein Zapfenlager (25) angeordnet ist.
